Europäisches Patentamt

European Patent Office

Office européen des brevets

(19)

(11) **EP 0 549 791 B1**

(12) **EUROPÄISCHE PATENTSCHRIFT**

(45) Veröffentlichungstag und Bekanntmachung des Hinweises auf die Patenterteilung:
**16.07.1997 Patentblatt 1997/29**

(21) Anmeldenummer: **91909937.4**

(22) Anmeldetag: **01.04.1991**

(51) Int Cl.6: **H05K 3/46**, H05K 3/00, H05K 1/05, H05K 3/42

(86) Internationale Anmeldenummer:
**PCT/SU91/00055**

(87) Internationale Veröffentlichungsnummer:
**WO 92/17994 (15.10.1992 Gazette 1992/26)**

(54) **MEHRLAGENLEITERPLATTE UND VERFAHREN ZU IHRER HERSTELLUNG**

MULTILAYER PRINTED CIRCUIT BOARD AND METHOD OF MANUFACTURE

CARTE DE CIRCUITS IMPRIMES MULTICOUCHE ET PROCEDE DE FABRICATION

(84) Benannte Vertragsstaaten:
**AT CH DE FR GB LI**

(43) Veröffentlichungstag der Anmeldung:
**07.07.1993 Patentblatt 1993/27**

(73) Patentinhaber: **Aktsionernoe obschestvo otkrytogo tipa VNIIETO**
**Moskau (RU)**

(72) Erfinder:
• **ADASKO, Vladimir Iosifovich**
  **Moscow, 119131 (RU)**
• **VARDENBURG, Arnold Kurtovich**
  **Istra, 143500 (RU)**
• **EMELYANOV, Alexandr Lvovich**
  **Moscow, 119146 (RU)**
• **EMELYANOV, Viktor Lvovich**
  **Moscow, 121352 (RU)**
• **SELIVERSTOV, Lev Alexeevich**
  **Istra, 143500 (RU)**

• **SLONIMSKY, Alexandr Davydovich**
  **Istra, 143500 (RU)**
• **SKLYAROV, Nikolai Alexeevich**
  **Istra, 143500 (RU)**
• **TIKHONOV, Vladimir Ivanovich**
  **Istra, 143500 (RU)**
• **ROGOZHIN, Jury Fedorovich**
  **Istra, 143500 (RU)**
• **PILIPOSIAN, Pogos Mkrtychevich**
  **Istra, 143500 (RU)**

(74) Vertreter: **Beetz & Partner Patentanwälte**
**Steinsdorfstrasse 10**
**80538 München (DE)**

(56) Entgegenhaltungen:
EP-A- 0 198 928          DE-A- 2 515 875
DE-A- 3 518 975          DE-A- 3 520 945
US-A- 4 211 603          US-A- 4 604 799

## Beschreibung

Die vorliegende Erfindung bezieht sich auf die Herstellungstechnik von Leiterplatten, insbesondere auf Mehrlagenleiterplatten und Verfahren zu ihrer Herstellung.

Zugrundeliegender Stand der Technik

Es ist eine Konstruktion der doppelt kaschierten Leiterplatte auf metallischem Substrat bekannt, die Montage- und Zwischenverbindungslöcher aufweist (US, A, 3296099).

Bei dieser Konstruktion weist das metallische Substrat mit vorläufig hergestellten Löchern auf zwei Seiten und an Lochwänden einen Isolierstoffüberzug auf, auf dem eine erste und eine zweite Schicht des Leiterbildes angerodnet sind. Die Montage- und die Zwischenverbindungslöcher sind metallisiert und dienen, falls notwendig, zur Verbindung der Elemente der ersten und der zweiten Schicht des Leiterbildes.

In einer anderen Konstruktion der doppelt kaschierten Leiterplatte auf metallischem Substrat wird das Prinzip der Verbindung der Elemente der Leiterbildschichten mittels metallisierter Löcher ausgenutzt (US, A, 4496793). Bei dieser Konstruktion besitzt das metallische Substrat mit einer Vielzahl von Löchern grossen Durchmessers einen beiderseits befindlichen Isolierstoffüberzug, auf welchem auf der einen Seite des Substrats eine doppelt kaschierte Leiterplatte und auf der anderen Seite eine der Aussenschichten des Leiterbildes angeordnet ist. Die zweite Aussenschicht des Leiterbildes befindet sich auf der doppelt kaschierten Leiterplatte und ist von dieser durch eine Isolationsschicht getrennt. Alle Schichten des Leiterbildes (zwei Innen- und zwei Aussenschichten) sind mit Hilfe von metallisierten Durchgangslöchern miteinander verbunden, die durch das metallische Substrat verlaufen, indem sir die darin vorhandenen Löcher benutzen.

Ein anderes Prinzip der Verbindung der Leiterbildschichten miteinander mittels Schalthöckern ist in einer bekannten Konstruktion der Mehrlagenleiterplatte ausgenutzt (EPV, A, 0247575 A2). Diese Konstruktion, die eine nächstliegende technische Lösung ist, schliesst ein:

- ein metallisches Substrat;
- einen auf dem metallischen Substrat angeordneten Isolierstoffüberzug;
- eine erste und mindestens noch eine Schicht des Leiterbildes, von denen die erste Leiterbildschicht aus Metall gebildet und eine ihrer Seiten, die zur nächstfolgenden Leiterbildschicht gekehrt ist, aufgerauht ist. Die nächstfolgende (zweite) Leiterbildschicht wird aus einer polymeren Leiterpaste ausgeführt;
- eine zwischen der ersten und der zweiten Leiterbildschicht angeordnete Isolationsschicht;
- eine Vielzahl von Schalthöckern, die leitende Wege zwischen der ersten und der zweiten Leiterbildschicht bilden und aus einer polymeren Leiterpaste hergestellt sind.

Diese Konstruktion gewährleistet im ganzen die Schaltung von elektrischen und funktechnischen Bauelementen, weist jedoch eine Reihe von Beschränkungen auf:

- die Leiterplatte gestattet es nicht, elektrische und funktechnische Bauelemente mit Stiftanschlüssen zu montieren;
- die Leiterplatte besitzt eine unzureichend hohe Bauelementendichte, was durch Anwendung einer polymeren Leiterpaste in der Konstruktion und Durchführung der Operation der Folienätzung bedingt ist;
- die beschriebene Konstruktion ist für die Herstellung von gedruckten Endverbindern nicht vorgerichtet, was den Einsatzbereich dieser Konstruktion einschränkt.

Die in US, A, 3269099 geschilderte und vorstehend angeführte Konstruktion lässt es zu, auf ihrer Oberfläche beliebige elektrische und funktechnische Bauelemente zu montieren, jedoch ist die Bauelementendichte nicht hoch. Dies ist durch mehrere Ursachen hervorgerufen. Die erste besteht darin, dass bei der Ausbildung des Isolierstoffüberzuges um die Löcher trichterförmige Vertiefungen entstehen, was zur Notwendigkeit führt, die Abmessung der Kontaktflächen um die Löcher beim Herausführen der Aussenränder der Kontaktflächen auf den flachen Teil des Isolierstoffüberzuges zu vergrössern. Die zweite Ursache liegt darin, dass die geschlagene Konstruktion es nicht erlaubt, die Leiterplatte mehrlagig zu machen. Die dritte ist durch den Umstand bedingt, dass zum Verbinden der Schichten miteinander Löcher benutzt sind, die auf der Oberfläche der Leiterplatte recht viel Platz einnehmen, wenn man noch dazu die trichterförmigen Vertiefungen um die Löcher berücksichtigt, wodurch wodurch die Bauelementendichte herabgesetzt wird.

Eine Konstruktion der Mehrlagenleiterplatte auf metallischem Substrat (US, A, 44967993) bietet die Möglichkeit, die Montagedichte für elektrische und funktechnische Bauelemente dank der Mehrlagigkeit und der ebenen Aussenfläche zu erhöhen, aber das Vorhandensein der metallisierten Durchgangslöcher, die zum Verbinden der Schichten moteinander dienen, vermindert merklich die Bauelementendichte. Der Umstand, dass das metallische Substrat eine Vielzahl von Löchern hinreichend grossen Masses besitzt, setzt das Wärmestreuvermögen des Substrats herab.

Bekannt ist ein Verfahren zur Herstellung von Leiterplatten, das sich durch das Fehlen von chemischen Prozessen (ausser der Galvanik) kennzeichnet (US, A,4651417) und gemäss welchem man im Substrat der Leiterplatte aus einem thermoplastischen Material Löcher durchbohrt, die zur Herstellung im weiteren elektrischer Verbindungen zwischen den Schichten des Leiterbildes bestimmt sind. Danach bringt man das Substrat unter einer Presse unter, um in demselben Vertiefungen mit einer Grösse von etwa 0,05 mm auszubilden, die der Konfiguration der Leiterbildschichten entsprechen. Hiernach trägt man auf das Substrat mach der Methode der Magnetronzerstäubung eine Kupferschicht von 2 μm Dicke auf, und das Substrat wird geschliffen, wodurch das Metall nur in den Vertiefungen zurückbleibt und die Leiterbildschicht bildet. Notwendigenfalls kann die Metalldicke vor dem Schleifen durch galvanisches Aufwachsen vergrössert werden. Die Mehrlagenleiterplatten können nach diesem Verfahren durch Aufpressen von polymeren Zwischenlagen auf die Oberfläche des Substrats der Leiterplatte mit den hergestellten Leiterbildschichten erzeugt werden. Die Verbindungen zwischen den Schichten werden durch Bohren und Metallisieren der Löcher gleichzeitig mit der Metallisierung der Leiterbildschichten sichergestellt.

Es ist ein Verfahren zur Herstellung von Mehrlagenleiterplatten bekannt, das sich gegenüber den herkömmlichen Technologien durch eine merklich geringere Menge von schädlichen Abfällen kennzeichnet (EPV, A, 024775 A2) und eine am nächsten kommende technische Lösung darstellt. Bei diesem Verfahren wird auf ein metallisches Substrat eine Metallfolie mit Hilfe einer Klebe-Isolierzwischenlage aufgebracht. Die Klebe-Zwischenlage soll eine gute Adhäsion sowohl am Material des Substrats als auch an der Folie haben. Die Folie kann eine Kupfer- oder eine Aluminiumfolie sein. Zur guten Haftung der Folie an den folgenden Schichten wird ihre Oberfläche aufgerauht. Dann formiert man durch Ätzen nach dem bekannten Verfahren die erste Schicht des Leiterbildes. Auf dieselbe bringt man eine Isolationsschicht auf, in der man Fenster zum Aufschluss der ersten Leiterbildschicht an vorgegebenen Stellen bildet. Die Isolationsschicht kann nach dem Siebdruckverfahren aus einer polymeren Isolierpaste oder aus einem fotoempfindlichen Material hergestellt sein. Als dann füllt man die Fenster mit einer polymeren Leiterpaste aus. Nach der Polymerisation der Paste kann man die Oberfläche der Leiterplatte zum Entfernen von möglichen Verunreinigungen und zum Ebnen der Oberfläche schleifen. Daraufhin bringt man mittels der polymeren Leiterpaste nach dem Siebdruckverfahren die zweite Leiterbildschicht auf. Nach der Polymerisation der Polymeren Leiterpaste scheidet man auf die Elemente der zweiten Leiterbildschicht zwecks Erhöhung der Leitfähigkeit eine Nickel-Bor-Legierung und dann Kupfer nach einem chemischen Verfahren ab. Diese Überzüge sichern auch eine gute Lötfähigkeit der Leiterplat- und eine Beständigkeit gegen die Einwirkung des schmelzflüssigen Lots.

Das in Rede stehende Verfahren gestattet es, die Anzahl von Operationen, die zu beträchtlichen Mengen an schädlichen Abfällen führen, zu reduzieren und den Verbrauch an teueren metallkaschierten Plasten zu verringern, weist jedoch eine Reihe von Beschränkungen auf:

- die Leiterbildelemente, die Schalthöcker, die nach dem Siebdruckverfahren hergestellt sind, haben eine beträchtliche Streuung der geometrischen Abmessungen, was erstens die Bauelementendichte senkt und zweitens die Herstellung von angepassten elektrischen Leitungen behindert sowie folglich den Arbeitsfrequenzbereich derartiger Leiterplatten begrenzt;

- die Anwendung der Folienätzung bei der Herstellung der ersten Leiterbildschicht, der chemischen Vernickelung und Verkupferung führt nicht nur zum Auftreten von Ionenverunreinigungen, zur Senkung des Isolationswiderstandes und Verminderung der Zuverlässigkeit der Leiterplatten, sondern auch zur Entstehung einer grossen Menge an schädlichen industriellen Abprodukten.

Das vorstehend angeführte Verfahren zur Herstellung von Mehrlagenleiterplatten (US, A, 4651417) macht es zwar möglich, die industriellen Abprodukte auf ein Minimum zu reduzieren, kennzeichnet sich aber durch eine niedrige Zuverlässigkeit, weil die Anwendung des Magnetronzerstäubungsverfahrens für die Metallisierung es nicht gestattet, die erforderliche Metallisierungsdicke besonders an den Lochwänden zu erzielen.

Tatsächlich kann die mittlere Metallisierungsdicke d im Loch folgende Grössen nicht übersteigen:

$$d \geq \frac{D}{4h} \cdot t$$

- bei der Abscheidung auf einer Seite,

$$d \geq \frac{D}{2h} \cdot t$$

- bei der Abscheidung auf zwei Seiten, und dies bedeutet, dass bei einem Durchmesser des Lochs von D = 0,9 mm, einer Dicke der Platte von h = 1,5 mm und einer Dicke der abgeschiedenen Schicht auf der Oberfläche der Leiterplatte von t = 2 μm die mittlere Metallschicht an den Wänden der Löcher bei der Abscheidung von zwei Seiten her 0,6 μm nicht übersteigt, d.h., sie ist kleiner als die Durchschnittsgrösse der Mikrounebenheiten der Oberfläche der Lochwände. Daher ist es bei einer solchen Dicke schwer, nicht nur auf eine hohe Zuverlässigkeit der elektrischen Verbindung, sondern auch auf eine gute Qualität der durch nachfolgendes galvanisches Aufwachsen aufgetragenen Überzüge der Lochwände zu rechnen. Es ist unmöglich, die Metallisierungsdicke durch Abscheidung im Vakuum ohne Lösung einer Reihe von spezifischen Problemen zu vergrössern, die mit der Adhäsionsfestigkeit der metallischen Beläge am polymeren Substrat der Leiterplatte, mit der Verbesserung von mechanischen und elektrischen Eigenschaften des Metalls des Überzuges u.a.m. zusammenhängen.

Bei der Schaffung von Mehrlagenleiterplatten nach dem genannten Verfahren nehmen die Probleme mit der Metallisierung der Löcher im Zusammenhang mit der Vergrösserung der Dicke der Leiterplatte und dem Vorhandensein einer Grenze zwischen dem Substrat und der aufgepressten Zwischenlage zu.

Offenbarung der Erfindung

Der vorliegenden Erfindung ist die Aufgabe zugrundegelegt, eine Mehrlagenleiterplatte zu schaffen, die für die Montage sowohl von oberflächlich montierbaren elektrischen und funktechnischen Bauelementen als auch von elektrischen und funktechnischen Bauelementen mit Stiftschlüssen geeignet ist und eine hohe Bauelementendichte, ein hohes Wärmestreuvermögen und eine hohe Zuverlässigkeit gewährleistet, sowie ein Verfahren zur Herstellung einer Mehrlagenleiterplatte anzugeben, das die Stabilität und Reproduzierbarkeit der Charakteristiken von Mehrlagenleiterplatten gewährleisten und es gestatten würde, die Nomenklatur der verwendeten chemischen Stoffe und die Menge von schädlichen industriellen Abprodukten bis hin zur Schaffung einer vollständig umweltfreundlichen Produktion zu verringern.

Die gestellte Aufgabe wird dadurch gelöst, dass in der Mehrlagenleiterplatte, die ein metallisches Substrat mit einem Isolierstoffüberzug enthält, auf welchen eine erste Schicht des Leiterbildes mit Leitern und mindestens eine zusätzliche Schicht des Leiterbildes mit Leitern und Kontaktflächen aufgebracht ist, welche Schichten durch eine Isolationsschicht voneinander getrennt sind, die Schalthöcker zur Verbindung der Leiter und Kontaktflächen der Leiterbildschichten beinhaltet, erfindungsgemäss der Isolierstoffüberzug auf das metallische Substrat auf zwei Seiten desselben aufgetragen ist, während die erste Leiterbildschicht zumindest auf eine Seite des Isolierstoffüberzuges aufgebracht ist, wobei in den Leiterbildschichten, in der Isolationsschicht, im Isolierstoffüberzug und im metallischen Substrat durchgehende Löcher gleichachsig ausgeführt sind und wobei die Löcher des metallischen Substrats einen Durchmesser besitzen, der grösser als der Durchmesser aller übrigen Löcher um die verdoppelte Dicke des auf die Lochwände aufgetragenen Isolierstoffüberzuges ist, und ausserdem an die Kanten der in den Leiterbildschichten und in der Isolationsschicht ausgeführten Löcher Kontaktflächen angrenzen, deren Dicke der Summe der Dicken der Leiterbildschichten und der Isolationsschicht gleich ist und die von einer Isolation umgeben sind, während die Stirnflächen sämtlicher Kontaktflächen eine gezahnte Form haben, die der Form der mit ihnen kontaktierenden Kanten der Isolation in den Schichten der Leiterbilder und in der Isolationsschicht entspricht, wobei die Isolierstoffüberzüge des Substrats und der Löcher eine vorgegebene Dicke aufweisen, die über ihre gesamte Oberfläche gleich ist.

Die erfindungsgemässe Konstruktion der Mehrlagenleiterplatte kann mit gedruckten Endverbindern mit Lammelen versehen sein, deren Dicke gleich der Summe der Dicken der Leitbildschichten und der Isolationsschicht ist, während die Stirnflächen aller Lamellen eine gezahnte Form haben, die der Form der mit ihnen kontaktierenden Kanten der Isolation und der Isolationsschicht entspricht.

Es ist zweckmässig, dass das metallische Substrat aus einem Metall mit einem niedrigen Wert des dehnungskoeffizienten besteht.

Zur Schaffung von elektromechanischen Einrichtungen auf der Basis von Mehrlagenleiterplatten stellt man das metallische Substrat aus Elektroblech her.

Die gestellte Aufgabe wird auch dadurch gelöst, dass nach dem Verfahren zur Herstellung von Mehrlagenleiterplatten, das darin besteht, dass man auf ein metallisches Substrat einen Isolierstoffüberzug aufträgt, auf welchem man die Leiter einer ersten Schicht des Leiterbildes formiert, dann eine Isolationsschicht aufbringt, in der man Fenster zum Aufschluss der ersten Leiterbildschicht an vorgegebenen Stellen ausführt, die Fenster mit einem elektrisch leitenden Material unter Bildung von Schalthöckern ausfüllt, die Oberfläche der Isolationsschicht mechanisch bearbeitet, wonach man auf dieser die Leiter- und Kontaktflächen einer zweiten Schicht des Leiterbildes formiert und sie vermittels der Schalthöcker mit den Leitern der ersten Leiterbildschicht verbindet, erfindungsgemäss man in dem metallischen Substrat vorläufig Löcher herstellt und den Isolierstoffüberzug auf eine der Seiten des metallischen Substrats und auf die Wände der Löcher aufträgt und die Oberfläche des Isolierstoffüberzuges mechanisch bearbeitet, indem man die unbedeckte Seite des metallischen Substrats als Basisseite benutzt, wonach man den Isolierstoffüberzug auf die andere Seite des metallischen Substrats aufträgt und seine Oberfläche mechanisch bearbeitet, indem man die bearbeitete Seite des Isolierstoffüberzuges als Basisseite benutzt, wobei man auf der ersten Schicht Kontaktflächen zusätzlich formiert und wobei man die Formierung der Leiter und Kontaktflächen der ersten und der zweiten Leiterbildschicht sowie die Ausfüllung der Fenster der Isolationsschicht mit dem elektrisch leitenden Material durch Abscheidung des elektrisch leitenden Materials mit einer Dicke über 15 µm aus der Dampfphase vornimmt.

Als Material der Isolationsschicht wird zweckmässigerweise eine lichtempfindliche Komposition gewählt, die ein Dianepoxioligomer der Molekularmasse 860 - 1070, Oligoesterakrylat, das Produkt der Veresterung von 1 Mol Dianepoxioligomer der Molekularmasse 860 - 1070 mit 1 bis 1,2 Mol der Methakrylsäure, 0,9 Mol der Sebazinsäure und 0,1 Mol der gesättigten aliphatischen Monokarbonsäure der Molekularmasse 130 - 160, einen polymerisationsanreger sowie ein Lösungsmittel und funktionale Zusätze bei dem folgenden Verhältnis der Komponenten in Masseteilen einschliesst:

| Dianepoxioligomer | 7 - 15 |
|---|---|
| Oligoesterkrylat | 4 - 10 |
| Produkt der Veresterung des Dianepoxioligomers | 30 - 45 |
| Fotopolymerisationsanreger | 4 - 10 |
| Lösungsmittel | 20 - 40 |
| funktionale Zusätze | 5 - 20. |

Es ist bevorzugt, weniger als ein Zehntel des elektrisch leitenden Material nach der Methode der Magnetronzerstäubung im Regime der Maximalspannung am Target abzuscheiden und den übriggebliebenen Teil nach der Methode der Elektronenstrahlverdampfung und Kondensation im Regime der grössten Verdampfungsgeschwindigkeit abzuscheiden.

Es ist zweckmässig, die Abscheidung des elektrisch leitenden Materials mit der Kühlung der aufgebrachten Schicht abzuwechseln und dabei die Abscheidung beim Erreichen der Grenztemperatur des elektrisch leitenden Materials zu unterbrechen und dieselbe nach 1 bis 10 Minuten wiederaufzunehmen.

Kurze Beschreibung der Zeichnungen

Im folgenden wird die vorliegende Erfindung an konkreten Ausführungsbeispielen derselben und anhand von beigefügten Zeichnungen näher erläutert, in denen es zeigt:

Fig. 1 eine Variante der Konstruktion der lagenleiterplatte mit zwei Leiterbildschichten, gemäss der Erfindung;
Fig. 2 den Aufbau der Kontaktfläche um ein Montageloch, gemäss der Erfindung;
Fig. 3 die Konstruktion der Leiterplatte mit den Lamellen von gedruckten Endverbindern, gemäss der Erfindung;
Fig. 4 einen Schnitt durch die Lamellen der gedruckten Endverbinder nach Linie IV-IV der Fig. 3;
Fig. 5 eine Variante des Ablaufschemas des technologischen Prozesses bei der Herstellung einer Leiterplatte, die zwei Leiterbildschichten enthält, gemäss der Erfindung.

Beste Ausführungsform der Erfindung

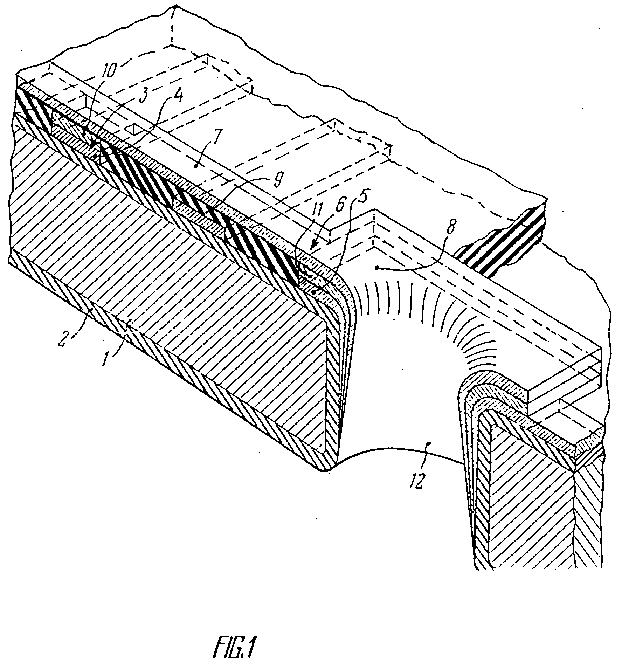

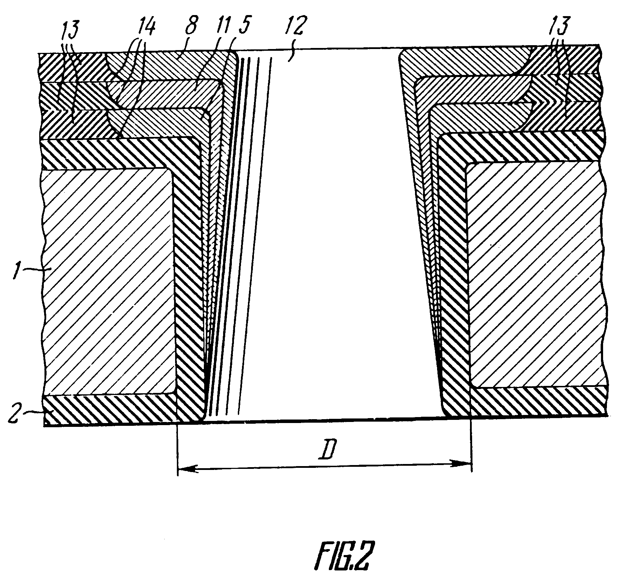

Die Mehrlagenleiterplatte enthält ein metallisches Substrat 1 (Fig. 1) mit einem auf jede von seinen Seiten aufgetragenen Isolierstoffüberzug 2. Auf einer der Seiten des Überzuges 2 ist eine Schicht 3 des Leiterbildes mit Leitern 4 und Kontaktflächen 5 und eine Schicht 6 des Leiterbildes mit Leitern 7 und Kontaktflächen 8 formiert, welche Schichten durch eine Isolationsschicht 9 getrennt sind, die Schalthöcker 10 und Kontaktfläche 11 enthält. In den Leiterbildschichten 3,6, in der Isolationsschicht 9, im Isolierstoffüberzug 2 und im metallischen Substrat 1 sind durchgehende Löcher 12 gleichachsig ausgeführt. Die Löcher 12 des metallischen Substrats 1 haben einen Durchmesser D (Fig. 2) grösser als der Durchmesser aller übrigen Löcher 12 um die verdoppelte Dicke des auf ihre Wandung aufgetragenen Isolierstoffüberzuges 2. An die Kanten der Löcher 12, die in den Leiterbildschichten 3,6 (Fig. 1) und in der Isolationsschicht 9 ausgeführt sind, grenzen die Kontaktflächen 5,8,11 an, deren Dicke gleich der Summe der Dicken der Leiterbildschichten 3,6 und der Isolationsschicht 9 ist. Die Kontaktflächen 5,6,11 sind von einer Isolation 13 (Fig. 2) umgeben, und ihre Stirnflächen 14 weisen eine gezahnte Form auf, die der Form der mit ihnen kontaktierenden Kanten der Isolation 13 (Fig. 2) entspricht.

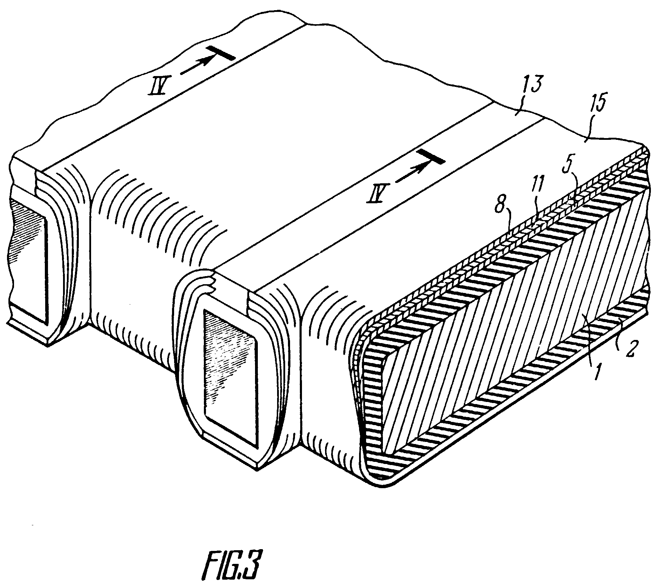

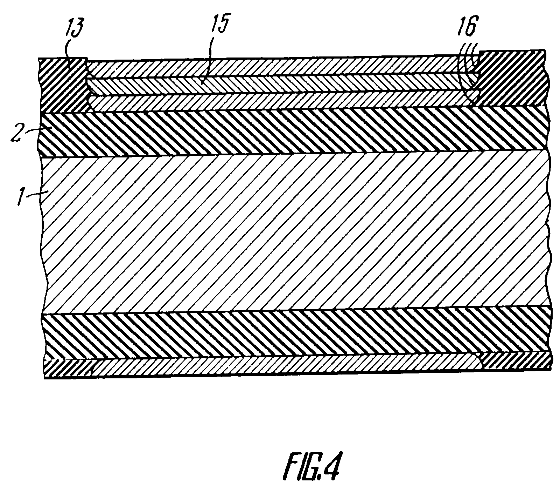

Die Mehrlagenleiterplatte kann End-Kontaktverbinder mit Lamellen 15 (Fig. 3) besitzen, deren Dicke gleich der Summe der Leiterbildschichten 3,6 (Fig. 1) und der Isolationsschicht 9 ist, während die Stirnflächen 16 (Fig. 4) sämtlicher Lammelle 15 eine gezahnte Form haben, die der Form der mit ihnen kontaktierenden Kanten der Isolation 13 entspricht.

Das erfindungsgemässe Verfahren zur Herstellung von lagenleiterplatten wird folgenderweise durchgeführt. Für das metallische Substrat 1 werden Bleche aus Aluminiumlegierungen, Kupfer, Legierungen mit einem niedrigen Wert des Temperaturausdehnungskoeffizienten sowie Elektrobleche verwendet. Platinen der erforderlichen Grösse werden durch Stanzen, Laser-Ausschneiden und nach anderen bekannten Verfahren erhalten, die die Herstellung von unverformten Platinen sicherstellen. Die Dicke der Platinen wird aus den konstruktiven Überlegungen heraus gewählt oder ist durch elektromagnetische und andere Eigenschaften der Substrate 1 gegeben.

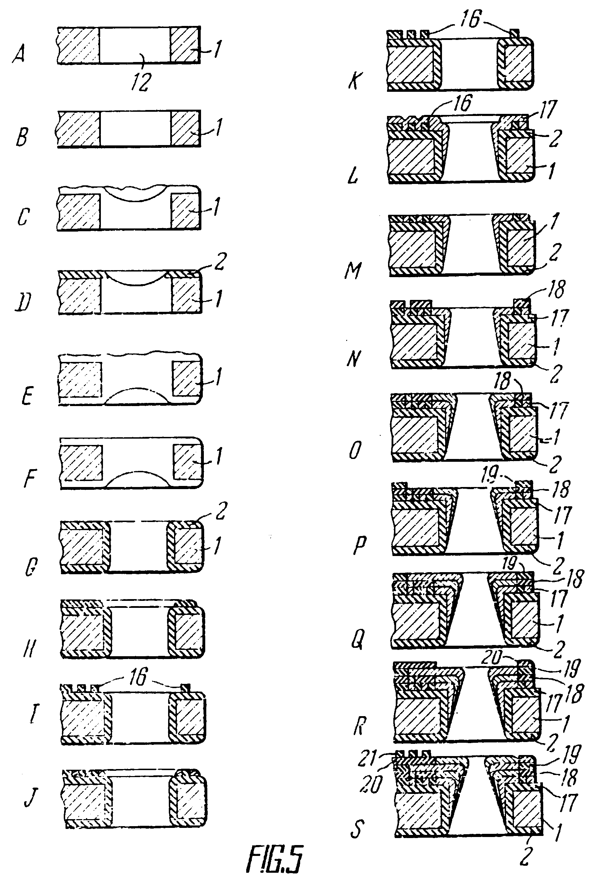

Bei der Herstellung der Platinen der Substrate 1 durch Laser-Ausschneiden stellt man im Substrat 1 gleichzeitig Fixierungs- und Montagelöcher 12 (Position A in Fig. 5) her. Diese Löcher können auch nach anderen Verfahren eingearbeitet werden, wichtig ist, dass die Platine dabei nicht verformt wird.

Mit dem Zweck, die Oberfläche des Substrats 1 von Verunreinigungen zu säubern, der Substratoberfläche eine bestimmte Rauheit zu verleihen, die Kanten der Löcher 12 abzurunden, unterwirft man das Substrat 1 dem Nassgleitschleifen (Position B) mittels eines Mikropulvers z.B. aus Elektrokorund mit der Körnigkeit von 40 µm. Der dabei erzielbare Wert der Rauheit $R_a$ beträgt 0,8 bis 20 µm, was günstig ist, um im weiteren eine gute Adhäsion des Überzuges am Substrat 1 zu erreichen.

Vor dem Auftragen des Isolierstoffüberzuges 2 (Fig. 1) schützt man die Fixierungslöcher mit Hilfe von speziellen Stopfen. Den Isolierstoffüberzug 2 auf dem metallischen Substrat 1 stellt man aus einer pulverförmigen Epoxidharz-Kompoundmasse her, beispielsweise der unten folgenden Zusammensetzung in Masseteilen:

| | |
|---|---|
| Epoxidharz | - 64 |
| Didiandiamid | - 1, 4 |
| Titandioxid | - 30 |
| Polyvinylbutyral | - 2 |
| Aerosil | - alles übrige, |

durch Abscheidung des Pulvers im Aerosol bei einer Spannung des elektrostatischen Feldes von 4000 bis 5000 V/cm und einem Potential an Hochspannungselektroden von 40000 bis 50000 V. Den Überzug 2 trägt man dabei auf eine Seite des Substrats 1 und auf die Wandung des Loches 12 auf, indem man die zweite Seite des Substrats 1 vor dem Gelangen des Pulvers mittels einer Spezialausrüstung bewahrt, erwärmt man denselben bis zum Schmelzen und polymerisiert ihn teilweise, worauf man noch eine Schicht aufträgt und diese bei der Temperatur von 180°C im Laufe einer 0,5 Stunde polymerisiert. Die Dicke des polymerisierten Überzuges, aufgetragen in zwei Etappen, beträgt 0,3 bis 0,4 mm (Position C).

Vor der mechanischen Bearbeitung des Isolierstoffüberzuges 2 bearbeitet man die unbedeckte Seite des Substrats 1 zum Entfernen von zufällig auf diese Oberfläche gelangten Teilchen der Kompoundmasse. Den Isolierstoffüberzug 2 bearbeitet man mechanisch, z.B. schleift man ihn bis zur Dicke von 0,2 mm mittels einer Schleifscheibe mit einer Körnung von 40 µm bei einer Umlaufgeschwindigkeit von 2500 U/min, wobei man als Kühlflüssigkeit destilliertes Wasser benutzt (Position D).

Den Isolierstoffüberzug 2 auf der anderen Seite des Substrats 1 erhält man in ähnlicher Weise, polymerisiert ihn jedoch im Laufe einer Stunde (Position E, F).

Danach bohrt man in der Epoxidharz-Kompoundmasse Montagelöcher mit einem Durchmesser, der 0,40 bis 0,45 mm kleiner als der Durchmesser der Löcher 12 im metallischen Substrat 1 ist (Position G, Fig. 5). Mit dieser Arbeitsoperation wird die Dicke der Isolierung 2 in den chern 12 bestimmt.

Durch Nassgleitschleifen verleiht man der Oberfläche des Isolierstoffüberzuges 2 eine bestimmte Rauheit ($R_a$ = 0,5 ... 1,25 µm), reinigt man die Oberfläche des Substrats 1 und der Löcher 12 von den Teilchen des Isolierstoffüberzuges 2, die sich bei der mechanischen Bearbeitung gebildet haben, und rundet die Kanten der Löcher 12 ab.

Zur Formierung der Leiter 4 und der Kontaktflächen 5 der Leiterbildschicht 3 bringt man auf diejenige Seite des Substrats 1, auf welche die Epoxidharz-Kompoundmasse in zweiter Linie aufgetragen wurde, beispielsweise nach der Methode des siebgraphischen Drucks über ein reines Sieb (ohne Bild) eine lichtempfindliche Komposition (Position H) der folgenden Zusammensetzung in Masseteilen auf:

| | |
|---|---|
| Epoxidharz | - 10 |
| Oligoesterakrylat | - 5 |
| Produkt der Veresterung von 1 Mol des Epoxidharzes durch eine Mischung von 1,2 Mol der Methakrylsäure, 0,9 Mol der Sebazinsäure und 0,1 Mol der synthetischen Fettsäuren der Fraktion $C_7$-$C_9$ | - 37 |
| Gemisch von Benzophenon und Michlers Keton | - 7 |
| Gemisch von Lösungsmitteln | - 30 |
| funktionale Zusätze /Pigmente, Füllstoff, Schaumverhütungsmittel u.a./ | - 11. |

Eine Vergrösserung des Gehalts an Veresterungsprodukt in der Komposition ebenso wie ein niedrigerer Epoxidharzgehalt führt zur Senkung der thermischen Beständigkeit der Überzüge 2. Eine Verminderung des Gehalts an Veresterungsprodukt setzt die Adhäsion der Überzüge herab. Eine Vergrösserung des Gehaltes an Epoxidharz oder eine Verringerung der Menge von einzuführenden Fotopolymerisationsanregern ruft eine Senkung der Lichtempfindlichkeit der Komposition hervor.

Die aufgebrachte Schicht der lichtempfindlichen Komposition trocknet man bei einer Temperatur nicht höher als 52°C. Nach dem Trocknen soll die Schichtdicke 40 bis 50 µm betragen.

Die ausgetrocknete Schicht der lichtempfindlichen Komposition belichtet man über die Fotoschablone der Leiterbildschicht 3 (Position J). Nach der Entwicklung des Bildes in einer Mischung von Äthylzellosolve mit Wasser (im Verhältnis 85:15 bezogen auf die Masse) trocknet man das erhaltene Isolationsrelief 16 (Position K) in einem starken Strahl reiner Luft und nimmt dann das Trocknen bei 80°C vor, worauf man das genannte Isolationsrelief mit Ultraviolettstrahlung bestrahlt und thermisch behandelt, indem man die Temperatur stufenweise (viermal) oder stetig von 120 bis 200°C erhöht.

Das Isolationsrelief 16 erhält man, wenn dies die Konfiguration der Leiterbildschichten 3 gestattet, nach dem Siebdruckverfahren unter Verwendung von bekannten Kompositionen auf Epoxidharzbasis, welche für die Erzeugung einer Schutzmaske bei der Herstellung von Leiterplatten (Position 1) angewendet werden.

Das Substrat 1 der Leiterplatte mit dem Isoliertoffüberzug 2 und dem Isolationsrelief 16 überzieht man ferner im Vakuum mit einer Metallschicht 17 von mindestens 15 µm Dicke (Position L). Dazu scheidet man zunächst eine Unterschicht aus Kupfer mit etwa 1 µm Dicke nach der Methode der Magnetronzerstäubung ab. Die Zerstäubung führt man im Regime der höchsten Spannung am Torget durch, bei welcher die Zerstäubungsgeschwindigkeit noch nicht merklich abnimmt. Ein solches Regime gewährleistet die erforderliche Adhäsion des Metalls am Isolierstoffüberzug (2 N/cm).

Die Hauptmasse des Kupfers scheidet man durch Elektronenstrahlverdampfung bei der gröstmöglichen Verdampfungsgeschwindigkeit ab, was die Herstellung von Kupferüberzügen mit annehmbaren mechanischen Eigenschaften (Reisstestigkeit 450 bis 510 N/mm$^2$, Bruchdehnung 2,0 bis 2,6%) gewährleistet. Damit der Isolierstoffüberzug 2 während der Abscheidung des Metalls auf denselben nicht überhitzt wird, unterbricht man den Abscheidungsvorgang, nachdem der Isolierstoffüberzug 2 die höchstzulässige Temperatur erreicht hat. Während der auf die Abscheidung folgenden Pause sinkt die Temperatur des Isolierstoffüberzuges 2, und nach einer gewissen Zeit nimmt man den Verdampfungsprozess wieder auf. Bei einer grösseren Pause von über 10 Minuten zwischen den Verdampfungszyklen nimmt die Zeit der Abscheidung des Überzuges 2 zu und es entsteht die Gefahr seiner Schichtung. Bei zu kleinen Pausen werden die mechanischen Eigenschaften des abgeschiedenen Metalls schlechter und es verschlechtert sich der Ausnutzungsfaktor des Metalls.

Um die Konfiguration der Leiterbildschicht 3 zu erhalten, muss man das Metall von den hervorstehenden Teilen des Isolationsreliefs 16 entfernen. Dies wird durch mechanische Bearbeitung, beispielsweise durch Präzisionsschleifen, erzielt (Position M).

Zur Herstellung der Isolationsschicht 9, die Fenster aufweist, welche mit einem elektrisch leitenden Material zur Bildung der Schalthöcker 10 ausgefüllt werden, wiederholt man den technologischen Prozess, d.h., man erhält ein Isolationsrelief 18 (Position N), indem man eine Schicht der lichtempfindlichen Komposition über die Fotoschablone der Schalthöcker 10 belichtet. Man bringt eine Kupferschicht auf die gesamte Oberfläche des Isolationsreliefs 18 auf und entfernt das Kupfer von den hervorstehenden Abschnitten des Isolationsreliefs 18 durch Präzisionsschleifen (Position O).

Die Formierung der Bildleiterschicht 6 führt man ähnlich aus. Man ehrält ein Isolationsrelief 19, das der Konfiguration der Leiterbildschicht 6 entspricht (Position P). Man bringt das Kupfer auf die Oberfläche des Isolationsbildes auf und entfernt es von den hervorstehenden Abschnitten (Position Q).

Die ausgebildete Struktur, die zwei Schichten von Signalleitern enthält, entspricht einer herkömmlichen doppelt kaschierten Leiterplatte und kann durch Ansetzen der dritten und der nachfolgenden Leiterbildschichten weiterentwikkelt werden, die durch Isolationsschichten voneinander getrennt sind, welche Schalthöcker zur Verbindung der Schichten miteinander enthalten.

Um die Herstellung der Leiterplatte abzuschliessen, bringt man auf sie eine Schutzmaske 20 (Position R) z.B. aus der vorerwähnten lichtempfindlichen Komposition auf und verzinnt die Kontaktflächen (Position S). Danach trägt man eine Markierung 21 auf und schneidet die Platte nach dem Umriss aus.

Die vorgeschlagene Erfindung gestattet es:

- die Menge an schädlichen Abfällen bei der Herstellung von Leiterplatten durch Beseitigung der chemischen und galvanischen Metallisierung, des Ätzens und Unterätzens von Metallen und einiger anderer Prozesse bedeutend herabzumindern, bis hin zur Schaffung einer umweltfreundlichen Produktion von Leiterplatten;
- die Bauelementendichte durch Verringerung der Abmessungen der Schalthöcker 10, der Breite der Linien und Zwischenräume zwischen ihnen zu erhöhen, da im erfindungsgemässen Prozess auf das Auflösungsvermögen solche Faktoren wie die Vergrösserung der Abmessungen der Leiter beim galvanischen Aufwachsen und ihr Unterätzen bei der Ätzung des Bildes keinen Einfluss ausüben und die Bauclementendichte nur durch das Auflösungsvermögen fotochemischer Prozesse bestimmt wird;

- die Zuverlässigkeit der Leiterplatten zu erhöhen dank dem Fehlen von Ionenverunrenigungen bei der Herstellung der Leiterplatten sowie dank den festen in ein Dielektrikum versenkten und zuverlässig mit ihm verbundenen Kontaktflächen und Lamellen 15 der Endverbinder.

Gewerbliche Verwertbarkeit

Die Erfindung kann in allen Fällen erfolgreich angewendet werden, wo herkömmliche auf metallkaschierten Plättchen hergestellt Leiterplatten einsetzbar sind, besonders bei hohen Anforderungen an die ökologischen Charakteristiken des Produktionsprozesses.

Mit besonderem Erfolg kann die Erfindung benutzt werden:

- für Leiterplatten, die elektrische und funktechnische Bauelemente mit hoher Wärmeentwicklung besitzen;
- für Leiterplatten, welche die Formierung von angepassten elektrischen Leitungen erfordern;
- für Leiterplatten von elektromechanischen Einrichtungen;
- für Leiterplatten, die keramische elektrische und funktechnische Bauelemente ohne Anschlüsse sowie Elemente mit Stiftanschlüssen gleichzeitig besitzen.

**Patentansprüche**

1. Mehrlagenleiterplatte, die ein metallisches Substrat (1) mit einem Isolierstoffüberzug (2) enthält, worauf eine Schicht (3) des Leiterbildes mit Leitern (4) und mindestens eine zusätzliche Schicht (6) des Leiterbildes mit Leitern (7) und Kontaktflächen (8) aufgebracht sind, wobei die Schichten (3, 6) durch eine Isolationsschicht (9) voneinander getrennt sind, in der Schalthöcker (10) zur Verbindung der Leiter (4, 7) und der Kontaktflächen (11) der Leiterbildschichten (3, 6) miteinander liegen, **dadurch gekennzeichnet, daß** der Isolierstoffüberzug (2) auf das metallische Substrat (1) auf zwei Seiten desselben aufgetragen ist, während die Leiterbildschicht (3) zumindest auf eine Seite des Isolierstoffüberzuges (2) aufgebracht ist, wobei in den Leiterbildschichten (3, 6), in der Isolationsschicht (9), im Isolierstoffüberzug (2) und im metallischen Substrat (1) durchgehende Löcher (12) gleichachsig ausgeführt sind und wobei die Löcher (12) des metallischen Substrats (1) einen Durchmesser (D) besitzen, der um die doppelte Dicke des auf die Lochwände aufgetragenen Isolierstoffüberzuges (2) größer als der Durchmesser der übrigen gleichachsigen Löcher (12) ist, und daß außerdem an die Kanten der in den Leiterbildschichten (3, 6) und in der Isolationsschicht (9) ausgeführten Löcher (12) Kontaktflächen (5, 8, 11) angrenzen, deren Dicke gleich der Summe der Dicken der Leiterbildschichten (3, 6) und der Isolationsschicht (9) ist und die von einer Isolation (13) umgeben sind, während die Stirnflächen (14) sämtlicher Kontaktflächen (8, 5, 11) eine gezahnte Form haben, die der Form der mit ihnen kontaktierenden Kanten der Isolation (13) in den Leiterbildschichten (3, 6) und in der Isolationsschicht (9) entspricht, wobei die Isolierstoffüberzüge (2) des Substrats (1) und der Löcher (12) eine vorgegebene Dicke aufweisen, die über ihre gesamte Oberfläche gleich ist.

2. Mehrlagenleiterplatte nach Anspruch 1, dadurch gekennzeichnet, daß sie mit gedruckten Endverbindern mit Lamellen (15) versehen ist, deren Dicke gleich der Summe der Dicken der Leiterbildschichten (3, 6) und der Isolationsschicht (9) ist, während die Stirnflächen (16) aller Lamellen (15) eine gezahnte Form haben, die der Form der mit ihnen kontaktierenden Kanten der Isolation (13) und der Isolationsschicht (9) entspricht.

3. Mehrlagenleiterplatte nach Anspruch 1, dadurch gekennzeichnet, daß das metallische Substrat (1) aus einem Metall mit kleinem Temperaturausdehnungskoeffizienten besteht.

4. Mehrlagenleiterplatte nach Anspruch 1, dadurch gekennzeichnet, daß das metallische Substrat (1) aus Elektroblech hergestellt ist.

5. Verfahren zur Herstellung von Mehrlagenleiterplatten, bei dem man auf ein metallisches Substrat (1) einen Isolierstoffüberzug (2) aufträgt, auf welchem man die Leiter (4) einer Leiterbildschicht (3) formt, dann eine Isolationsschicht (9) aufbringt, in der man Fenster zum Anschluß der Leiterbildschicht (3) an vorgegebenen Stellen ausführt, zur Bildung von Schalthökkern (10) die Fenster mit einem elektrisch leitenden Material ausfüllt, die Oberfläche der Isolationsschicht (9) mechanisch bearbeitet, wonach man auf dieser die Leiter (7) und die Kontaktflächen (8) einer Leiterbildschicht (6) formt und sie mittels der Schalthöcker (10) mit den Leitern (4) der Leiterbildschicht (3) verbindet,

**dadurch gekennzeichnet, daß** man in dem metallischen Substrat (1) vorläufig Löcher (12) herstellt und den Isolierstoffüberzug (2) auf eine der Seiten des metallischen Substrats (1) und auf die Wände der Löcher (12) aufträgt und die Oberfläche des Isolierstoffüberzuges (2) schleift, wobei man die unbedeckte Seite des metallischen Substrats (1) als Basisseite benutzt, wonach man den Isolierstoffüberzug (2) auf die andere Seite des metallischen Substrats (1) aufträgt und seine Oberfläche schleift, wobei man die bearbeitete Seite des Isolierstoffüberzuges (2) als Basisseite benutzt, wobei man auf der Schicht (3) Kontaktflächen (5) zusätzlich formt und die Formung der Leiter (4, 7) und der Kontaktflächen (5, 8) der Leiterbildschichten (3, 6) sowie die Ausfüllung der Fenster der Isolationsschicht (9) mit dem elektrisch leitenden Material durch Abscheidung des elektrisch leitenden Materials mit einer Dicke über 15 µm aus der Dampfphase vornimmt.

6. Verfahren nach Anspruch 5,
   dadurch gekennzeichnet, daß
   man als Material der Isolationsschicht (9) eine lichtempfindliche Zusammensetzung wählt, die ein Dianepoxioligomer der Molekularmasse 860 - 1070, Oligoesterakrylat, das Produkt der Veresterung von 1 Mol Dianepoxioligomer der Molekularmasse 860 - 1070 mit 1 bis 1,2 Mol der Methakrylsäure, 0,9 Mol der Sebazinsäure und 0,1 Mol der gesättigten aliphatischen Monokarbonsäure der Molekularmasse 130 - 160, einen Fotopolymerisationsanreger sowie ein Lösungsmittel und funktionale Zusätze bei dem folgenden Verhältnis der Komponenten in Masseteilen einschließt:

| | |
|---|---|
| Dianepoxioligomer | 7 - 15 |
| Oligoesterakrylat | 4 - 10 |
| Produkt der Veresterung des Dianepoxioligomers | 30 - 45 |
| Fotopolymerisationsanreger | 4 - 10 |
| Lösungsmittel | 20 - 40 |
| funktionale Zusätze | 5 - 20. |

7. Verfahren nach Anspruch 5,
   dadurch gekennzeichnet, daß
   man weniger als ein Zehntel des elektrisch leitenden Materials nach der Methode der Magnetronzerstäubung im Regime der Maximalspannung am Target abscheidet, während man den übriggebliebenen Teil nach der Methode der Elektronenstrahlverdampfung und Kondensation im Regime der größten Verdampfungsgeschwindigkeit abscheidet.

8. Verfahren nach Anspruch 7,
   dadurch gekennzeichnet, daß
   man die Abscheidung des elektrisch leitenden Materials mit der Kühlung der aufgebrachten Schicht abwechselt, wobei man die Abscheidung beim Erreichen der Grenztemperatur des elektrisch leitenden Materials unterbricht und dieselbe nach 1 bis 10 Minuten wieder aufnimmt.

**Claims**

1. A multi-layer circuit board comprising a metallic substrate (1) with an insulating coating (2), upon which are applied a layer (3) of the conductor pattern with conductors (4) and at least one additional layer (6) of the conductor pattern with conductors (7) and contact surfaces (8), wherein the layers (3, 6) are separated from one another by an insulating layer (9) in which are arranged connecting protuberances (10) for connecting the conductors (4, 7) and the contact surfaces (11) of the conductor pattern layers (3, 6) to one another, characterised in that the insulating coating (2) is applied to the metallic substrate (1) on both sides thereof, while the conductor pattern layer (3) is applied at least to one side of the insulating coating (2), wherein throughgoing apertures (12) are formed coaxially in the conductor pattern layers (3, 6), in the insulating layer (9), in the insulating coating (2) and in the metallic substrate (1), and wherein the apertures (12) of the metallic substrate (1) have a diameter (D) which exceeds the diameter of the other coaxial apertures (12) by double the thickness of the insulating coating (2) applied to the aperture walls, and that moreover the edges of the apertures (12), formed in the conductor pattern layers (3, 6) and in the insulating layer (9), are adjoined by contact surfaces (5, 8, 11) whose thickness is equal to the sum of the thicknesses of the conductor pattern layers (3, 6) and of the insulating layer (9) and which are surrounded by an insulation means (13), while the end faces (14) of all the contact surfaces (8, 5, 11) have a toothed formation which corresponds to the formation of the edges, with which they are contacted, of the insulation means (13) in the conductor pattern layers (3, 6) and in the insulating layer (9), the insulating coatings (2) of the substrate (1) and of the apertures (12) having a predetermined thickness which is the same over the whole of their surface.

2. A multi-layer circuit board according to Claim 1, characterised in that it is provided with printed terminal connectors having laminations (15) whose thickness is equal to the sum of the thicknesses of the conductor path layers (3, 6) and of the insulating layer (9), while the end faces (16) of all the laminations (15) possess a toothed formation which corresponds to the formation of the edges, with which they are contacted, of the insulation means (13) and of the insulating layer (9).

3. A multi-layer circuit board according to Claim 1, characterised in that the metallic substrate (1) is composed of a metal having a low temperature expansion coefficient.

4. A multi-layer circuit board according to Claim 1, characterised in that the metallic substrate (1) is produced from electrical sheet metal.

5. A process for the production of multi-layer circuit boards wherein an insulating coating (2) is applied to a metallic substrate (1), upon which insulating coating (2) the conductors (4) of a conductor pattern layer (3) are formed, whereupon an insulating layer (9) is applied, in which insulating layer (9) windows are formed for connecting the conductor pattern layer (3) at predetermined locations, the windows are filled with an electrically conductive material in order to form connecting protuberances, the surface of the insulating layer (9) is mechanically processed, and then the conductors (7) and contact surfaces (8) of a conductor pattern layer (6) are formed on said insulating layer (9) and are connected by means of the connecting protuberances (10) to the conductors (4) of the conductor pattern layer (3), characterised in that apertures (12) are temporarily formed in the metallic substrate (1) and the insulating coating (2) is applied to one of the sides of the metallic substrate (1) and to the walls of the apertures (12), and the surface of the insulating coating (2) is ground using the non-covered side of the metallic substrate (1) as base side, whereupon the insulating coating (2) is applied to the other side of the metallic substrate (1) and its surface is ground using the processed side of the insulating coating (2) as base side, wherein contact surfaces (5) are additionally formed on the layer (3) and the formation of the conductors (4, 7) and of the contact surfaces (5, 8) of the conductor pattern layers (3, 6) and the filling of the windows of the insulating layer (9) with the electrically conductive material is carried out by depositing the electrically conductive material in a thickness greater than is μm from the vapour phase.

6. A process according to Claim 5, characterised in that as material of the insulating layer (9) a light-sensitive composition is selected which includes a dianepoxy oligomer having a molecular weight of 860 - 1070, oligoester acrylate, the product of the esterification of 1 mol dianepoxy oligomer having a molecular weight of 860 - 1070 with 1 to 1.2 mol methacrylic acid, 0.9 mol sebacic acid and 0.1 mol saturated aliphatic monocarboxylic acid having a molecular weight of 130 - 160, a photopolymerisation activator together with a solvent and functional additives in the following component ratio in parts by weight:

| | |
|---|---|
| dianepoxy oligomer | 7 - 15 |
| oligoester acrylate | 4 - 10 |
| product of the esterification of the dianepoxy oligomer | 30 - 45 |
| photopolymerisation activator | 4 - 10 |
| solvent | 20 - 40 |
| functional additives | 5 - 20 |

7. A process according to Claim 5, characterised in that less than one tenth of the electrically conductive material is deposited by the magnetron sputtering method in accordance with the maximum voltage across the target, while the remaining part is deposited by the method of electron beam vaporisation and condensation in accordance with the maximum vaporisation speed.

8. A process according to Claim 7, characterised in that the deposition of the electrically conductive material alternates

EP 0 549 791 B1

with the cooling of the applied layer, wherein the deposition is interrupted when the limit temperature of the electrically conductive material is reached and the deposition is resumed after 1 to 10 minutes.

**Revendications**

1. Carte multicouche pour circuit imprimé qui se compose d'un substrat métallique (1) muni d'un revêtement (2) en matériau isolant, sur lequel sont appliquées une couche (3) du réseau conducteur avec des conducteurs (4) et au moins une couche supplémentaire (6) du réseau conducteur avec des conducteurs (7) et des surfaces de contact (8), dans laquelle les couches (3, 6) sont séparées l'une de l'autre par une couche d'isolation (9), des barrettes de commutation (10) pour assurer la liaison des conducteurs (4, 7) et des surfaces de contact (11) des couches (3, 6) de réseau conducteur étant disposées en coopération, caractérisées en ce que le revêtement (2) en matériau isolant est déposé sur le substrat métallique (1) sur deux faces de ce dernier, tandis que la couche de réseau conducteur (3) est déposée au moins sur une face du revêtement (2) en matériau isolant, en ce que dans les couches (3, 6) du réseau conducteur, dans la couche d'isolation (9), dans le revêtement (2) en matériau isolant, et dans le substrat métallique (1) sont réalisés coaxialement des trous traversants (12) et dans lequel les trous (12) du substrat métallique (1) présentent un diamètre (D) qui est majoré du double de l'épaisseur du revêtement (2) en matériau isolant, appliqué sur les parois des trous, par rapport au diamètre de la partie coaxiale restante des trous (12), et en ce qu'en outre, sur les bords des trous (12) réalisés dans les couches (3, 6) du réseau conducteur et dans la couche d'isolation (9), sont délimitées les surfaces de contact (5, 8, 11) dont l'épaisseur est égale à la somme des épaisseurs des couches (3, 6) du réseau conducteur et de la couche d'isolation (9) et qui sont entourés d'une isolation (13), tandis que les surfaces frontales (14) de toutes les surfaces de contact (8, 5, 11) présentent une forme dentée, correspondant à la forme des bords en contact avec ces surfaces de contact de l'isolation (13) dans les couches (3, 6) du réseau conducteur et dans la couche d'isolation (9), le revêtement (2) en matériau isolant du substrat (1) et des trous (12) présentant une épaisseur prédéterminée, qui est la même sur toute la surface.

2. Carte multicouche pour circuit imprimé selon la revendication 1, caractérisée en ce qu'elle est munie de connecteurs d'extrémité à lamelles (15), et dont l'épaisseur est égale à la somme de l'épaisseur des couches (3, 6) du réseau conducteur et de la couche d'isolation (9), tandis que les faces frontales (16) de toutes les lamelles (15) présentent une forme dentée, correspondant à la forme des bords en contact de l'isolation (13) et de la couche d'isolation (9).

3. Carte multicouche pour circuit imprimé selon la revendication 1, caractérisée en ce que le substrat métallique (1) est constitué d'un métal à faible coefficient de dilatation thermique.

4. Carte multicouche pour circuit imprimé selon la revendication 1, caractérisée en ce que le substrat métallique (1) est constitué de tôle électrique ou magnétique.

5. Procédé de fabrication de cartes multicouche pour circuit imprimé dans lequel on applique, sur un substrat métallique (1), un revêtement (2) en matériau isolant, sur lequel on forme les conducteurs (4) d'une couche (3) de réseau conducteur, on étend ensuite une couche d'isolation (9), dans laquelle on réalise des fenêtres pour le raccordement de la couche (3) de réseau conducteur en des emplacements prédéterminés, afin de former des barrettes de commutation (10) on remplit les fenêtres avec un matériau électriquement conducteur, on usine mécaniquement la surface de la couche d'isolation (9), et l'on forme ensuite sur cette surface les conducteurs (7) et les surfaces de contact (8) d'une couche (6) de réseau conducteur, et on les relie à l'aide des barrettes de commutation (10), aux conducteurs (4) de la couche (3) de réseau conducteur,
   caractérisé en ce qu'on réalise, dans le substrat métallique (1), tout d'abord des trous (12) et on applique le revêtement (2) en matériau isolant sur l'une des faces du substrat métallique (1) et sur les parois des trous (12) et l'on soumet à une rectification par meulage la surface du revêtement (2) en matériau isolant, on utilise la face découverte du substrat métallique (21) comme face de base, et on applique ensuite le revêtement (2) en matériau isolant sur l'autre face du substrat métallique (1), et on soumet la surface du revêtement à une rectification par meulage, puis on utilise la face rectifiée du revêtement (2) en matériau isolant comme face de base, on forme de façon supplémentaire des surfaces de contact (5) sur la couche (3) et on procède au formage des conducteurs (4, 7) et des surfaces de contact (5, 8) des couches (3, 6) de réseau conducteur, ainsi qu'au remplissage des fenêtres de la couche d'isolation (9) avec le matériau électriquement conducteur par précipitation du matériau électriquement conducteur sous une épaisseur supérieure à 15µm, à partir de la phase vapeur.

11

**6.** Procédé selon la revendication 5, caractérisé en ce qu'on choisit comme matériau de la couche d'isolation (9) une compostion sensible à la lumière, qui contient un diènépoxyoligomère de masse moléculaire 860 à 1070, un oligoester acrylate, le produit de l'estérification de 1 mole de dianépoxyoligomère de masse moléculaire 860 à 1070 par 1 à 1,2 mole d'acide méthacrylique, 0,9 mole d'acide sébasique, et 0.1 mole de l'acide monocarboxylique aliphatique saturé, de masse moléculaire 130 à 160, un activateur de photopolymérisation ainsi qu'un solvant et des additifs fonctionnels, selon le rapport suivant des composants, en parties en masse (en poids):

| | |
|---|---|
| Diènépoxyoligomère | 7 à 15 |
| Oligoester acrylate | 4 à 10 |
| Produit de l'estérification du dianépoxyoligomère | 30 à 45 |
| Activateur de photopolymérisation | 4 à 10 |
| Solvant | 20 à 40 |
| Additifs fonctionnels | 5 à 20 |

**7.** Procédé selon la revendication 5, caractérisé en ce que l'on précipite moins d'un dixième du matériau électriquement conducteur, selon le procédé de la pulvérisation au magnétron, au régime de la tension maximale sur la cible, tandis que l'on précipite la partie restante selon le procédé de la vaporisation par rayonnement électronique (émission thermoélectrique) et de la condensation au régime de la plus grande vitesse de vaporisation.

**8.** Procédé selon la revendication 7, caractérisé en ce qu'on fait alterner la précipitation du matériau électriquement conducteur avec le refroidissement de la couche appliquée, on interrompt la précipitation lorsqu'on atteint la température limite du matériau électriquement conducteur, et l'on reprend la précipitation après une à dix minutes.

FIG.1

FIG.2

FIG.3

13    15    16

2

1

FIG.4

FIG.5